# EUROPÄISCHE PATENTSCHRIFT

(11) **EP 2 038 624 B1**
(45) Veröffentlichungstag und Bekanntmachung des Hinweises auf die Patenterteilung: **10.09.2014**
(21) Anmeldenummer: 07785553.4
(22) Anmeldetag: 25.06.2007
(51) Int. Cl.: G01K 1/14, H05K 1/03, H05K 1/11, H05K 1/18, H05K 3/32

(54) **ELEKTRISCHES BAUELEMENT MIT EINEM SENSORELEMENT UND VERFAHREN ZUR VERKAPSELUNG EINES SENSORELEMENTS**
ELECTRIC COMPONENT COMPRISING A SENSOR ELEMENT AND METHOD FOR ENCAPSULATING A SENSOR ELEMENT
COMPOSANT ELECTRIQUE A ELEMENT CAPTEUR ET PROCEDE POUR ENCAPSULER UN ELEMENT CAPTEUR

(30) Priorität: 06.07.2006 DE 102006031344
(43) Veröffentlichungstag der Anmeldung: 25.03.2009
(73) Patentinhaber: EPCOS AG, 81669 München (DE)
(72) Erfinder: KLOIBER, Gerald, A-8073 Feldkirchen (AT); FELTZ, Adalbert, A-8530 Deutschlandsberg (AT); CERNOCH, Claus, 9020 Klagenfurt (AT)
(74) Vertreter: Epping - Hermann - Fischer
(86) Internationale Anmeldenummer: PCT/DE2007/001120
(87) Internationale Veröffentlichungsnummer: WO 2008/003287

(56) Entgegenhaltungen:
- DE-A1- 4 329 312
- DE-A1- 10 124 373
- GB-A- 2 186 438
- JP-A- 4 150 001
- JP-A- 11 326 072

## Beschreibung

Bauelemente mit Sensorelementen sind aus den Druckschriften DE 101 39 109 A1 bekannt. Aus der Druckschrift DE 197 40 262 C1 ist eine Sinterkeramik für NTC-Thermistoren bekannt.

In der Druckschrift JP 11-326072 A ist ein Sensorelement beschrieben, bei dem ein wärmeempfindlicher Film auf einem Substrat angeordnet, mit Leiterbahnen für den elektrischen Anschluss versehen und mit einem hitzebeständigen Isolationsfilm abgedeckt ist. Anschlussflächen der Leiterbahnen sind frei gelassen.

In der Druckschrift JP 04-150001 A ist ein Thermistorelement beschrieben, bei dem Widerstandsschichten mit hoher und niedriger Thermistorkonstante zwischen isolierenden Schichten aus einer Oxidkeramik angeordnet sind.

In der Druckschrift GB 2 186 438 A ist ein Verfahren zur Herstellung einer elektrischen und mechanischen Verbindung einer Membran mit dem Träger eines Drucksensors beschrieben, bei dem vor dem Aufkleben der Membran Beschichtungen aus einer Leiterpaste in Öffnungen des Trägers bis zu einer gewissen Tiefe eingebracht werden.

In der Druckschrift DE 101 24 373 A1 ist ein Temperaturfühler beschrieben, bei dem ein wärmeempfindliches Element in einem keramischen Gehäuse angeordnet ist. Das Gehäuse ist aus einer keramischen Substratschicht als Unterlage, einer keramischen Zwischenschicht mit einer Öffnung zur Aufnahme des wärmeempfindlichen Elementes und einer oberseitigen Keramikschicht gebildet.

In der Druckschrift DE 43 29 312 A1 ist ein Thermistor-Temperaturfühler beschrieben, der ein Schaltungsplättchen aus isolierendem Keramikmaterial und eine Vielzahl von auf dem Schaltungsplättchen angeordneten Heißleiterelementen aufweist. Mehrere Schaltungsplättchen können gestapelt und auf dem Stapel oberseitig und unterseitig Deckplättchen angeordnet sein.

Eine zu lösende Aufgabe besteht darin, ein elektrisches Bauelement mit einem Sensorelement anzugeben, das eine hohe mechanische Stabilität aufweist und sich in einem serienmäßigen, kostengünstigen Verfahren herstellen lässt.

Weitere zu lösende Aufgaben bestehen darin, ein Verfahren zur Verkapselung eines Sensorelements sowie ein Verfahren zur Herstellung einer Plattenanordnung mit integrierten Leiterbahnen anzugeben.

Gemäß einer ersten bevorzugten Ausführungsform wird ein elektrisches Bauelement mit einem Sensorelement angegeben, die in eine Plattenanordnung eingebettet ist. Die Plattenanordnung umfasst mindestens drei Platten und zwischen diesen angeordnete Leiterbahnen, welche mit dem Sensorelement leitend verbunden sind. Zumindest zwei der Leiterbahnen weisen freiliegende Bereiche auf.

Das als Verbundelement gebildete Bauelement zeichnet sich durch eine hohe mechanische Stabilität aus und ist zum Einsatz für Hochtemperaturanwendungen geeignet.

Gemäß einer zweiten bevorzugten Ausführungsform wird ein elektrisches Bauelement mit einer Plattenanordnung und einem in dieser eingeschlossenen Sensorelement angegeben. Die Plattenanordnung umfasst mindestens drei mit Leiterbahnen versehene Platten. Das Sensorelement ist über eine auf der Innenseite der endständigen Platte angeordnete Leiterbahn mit der Leiterbahn der mittleren Platte leitend verbunden. Die Innenseite der endständigen Platte ist die zur mittleren Platte gewandte, also von außen abgewandte Seite dieser Platte.

Nachstehend werden vorteilhafte Ausgestaltungen der beiden bevorzugten Ausführungsformen beschrieben.

Das Sensorelement ist vorzugsweise als ein hochtemperaturbeständiger Temperaturfühler ausgebildet. Das Sensorelement ist in einer vorteilhaften Variante als NTC-Thermistor ausgebildet und umfasst einen Körper, der NTC-Keramik enthält. NTC steht für Negative Temperature Coefficient. Die NTC-Keramik ist vorzugsweise alterungsbeständig. Die Keramikzusammensetzung basiert vorzugsweise auf einem phasenhomogenen System Ba^{II}ₓLa^{III}₁₋ₓTi^{IV}_{x+y}Co^{II}_{y}Co^{III}_{1-x-2y}O₃ mit Perowskitstruktur. Die Keramik mit der angegebenen Zusammensetzung zeichnet sich durch eine hohe Empfindlichkeit hinsichtlich einer Temperaturmessung aus. Auch andere, insbesondere in der Druckschrift DE 197 40 262 C1 beschriebene Keramikmaterialien, sind für das Sensorelement geeignet. Die Offenbarung dieser Druckschrift bezüglich der Keramikmaterialien wird hiermit durch Rückbezug aufgenommen.

Der Körper ist vorzugsweise ein flaches Gebilde mit beliebigem Querschnitt. Der Körper kann beispielsweise als eine Scheibe ausgebildet sein. Auf beiden Hauptflächen des Körpers ist vorzugsweise eine Elektrode angeordnet, die mit mindestens einer der Leiterbahnen der Plattenanordnung leitend verbunden ist.

Der Körper wird vorzugsweise gesintert. Die Leiterbahnen werden auf die Platten vorzugsweise als eine leitfähige Paste (Leiterpaste) z. B. in einem Siebdruckverfahren aufgebracht und eingebrannt. Die Leiterpaste, die auch zur Verbindung zwischen den verschiedenen Leiterbahnen sowie zwischen den Leiterbahnen und dem Sensorelement verwendet wird, enthält vorzugsweise Partikel aus AgPt, AgPd und/oder Pt. Die Leiterbahnen und die elektrischen Verbindungen mit diesen Eigenschaften zeichnen sich durch eine hohe Oxidations-/Reduktionsbeständigkeit aus.

Die Größe der Platten ist vorzugsweise derart gewählt, dass in mindestens einem Bereich der Plattenanordnung Stufen mit freigelegten Bereichen der Leiterbahnen gebildet sind.

Die Platten weisen vorzugsweise voneinander unterschiedliche laterale Abmessungen auf. In einer vorteilhaften Variante nimmt die laterale Abmessung von unten nach oben ab, oder umgekehrt. In einer weiteren Variante kann die mittlere Platte größer als beide endständigen Platten ausgebildet sein, so dass ein Bereich der mittleren Platte herausragt.

Die Platten umfassen zwei endständige und eine zwischen diesen angeordnete mittlere Platte, in der vorzugsweise eine durchgehende Öffnung zur Aufnahme des Sensorelements ausgebildet ist. Diese Öffnung kann im Prinzip durch eine Nische ersetzt werden, die dadurch gebildet ist, dass die mittlere Platte gegenüber den endständigen Platten abgesetzt ist. Die Dimension dieser Nische ist vorzugsweise an diejenige des Sensorelements angepasst.

Zumindest eine der endständigen Platten kann auch eine Öffnung haben, deren Querschnittsgröße allerdings vorzugsweise deutlich kleiner als diejenige des Sensorelements ist.

In einer vorteilhaften Variante ist auf der ersten endständigen Platte eine erste Leiterbahn ausgebildet, die mit dem Sensorelement leitend verbunden ist. Ein freiliegender Bereich der ersten Leiterbahn bildet vorzugsweise eine erste Kontaktfläche des Bauelements.

Auf der mittleren Platte ist vorzugsweise eine zweite Leiterbahn angeordnet. Ein freiliegender Bereich der zweiten Leiterbahn bildet vorzugsweise eine zweite Kontaktfläche des Bauelements.

Beide Kontaktflächen sind vorzugsweise von ein und derselben Seite des Bauelements kontaktierbar. Möglich ist aber auch, dass die Kontaktflächen von zwei gegenüber liegenden Seiten kontaktiert werden.

Auf der Innenseite, d. h. der zur mittleren Platte gewandten Hauptfläche der zweiten endständigen Platte ist vorzugsweise eine dritte Leiterbahn angeordnet, die das Sensorelement mit der zweiten Leiterbahn leitend verbindet. Die dritte Leiterbahn ist vorzugsweise komplett in der Plattenanordnung vergraben.

In einer weiteren Variante ist auf beiden Hauptflächen der mittleren Platte eine Leiterbahn ausgebildet, die mittels einer auf der Innenseite der jeweiligen endständigen Platte ausgebildeten, vorzugsweise verborgenen Leiterbahn mit dem Sensorelement leitend verbunden ist.

Die Platten umfassen vorzugsweise eine elektrisch isolierende Keramik, die z. B. Alox oder Si₃N₄ umfasst. Dadurch, dass das Sensorelement in einen Verbund der stabilen Platten mit isolierenden Eigenschaften integriert ist, ist im Betrieb des Bauelements eine gute elektrische Isolation gewährleistet.

Die aufeinander folgenden Platten sind in den von den Leiterbahnen freien Bereichen vorzugsweise durch eine Verbindungsschicht miteinander verbunden. Die Verbindungsschicht stellt vorzugsweise einen ausgehärteten Keramikkleber dar. Die Verbindungsschicht umfasst vorzugsweise Al₂O₃-Partikel. Die Verbindungsschicht kann ein Hochtemperaturglas enthalten, dessen Erweichungstemperatur über 1000°C liegt.

Die Leiterbahnen sind von den Seitenkanten der Plattenanordnung vorzugsweise beabstandet. Insbesondere können die freiliegenden Bereiche der Leiterbahnen gegenüber den Stufenkanten eingezogen sein.

Die Leiterbahnen weisen vorzugsweise eine Dicke von 10 bis 100 Mikrometer auf. Die Elektroden des Sensorelements weisen vorzugsweise eine Dicke bis 20 Mikrometer auf. Die Platten weisen vorzugsweise eine Dicke von 0,2 bis 1 mm auf.

Das angegebene Bauelement kann für Temperaturmessungen im Bereich von 1000°C eingesetzt werden. Daher ist es vorteilhaft, wenn die als Kontaktflächen vorgesehenen Bereiche der Leiterbahnen mit externen Anschlussleitungen verschweißt werden.

Die Plattenanordnung kann in einer Metallhülse angeordnet werden.

Des weiteren wird ein Verfahren zur Verkapselung eines Sensorelements angegeben. Dieses Verfahren umfasst die folgenden Schritte. Zunächst werden drei Platten mit Leiterbahnen und ein Sensorelement bereitgestellt. Die untere und die mittlere Platte werden zusammengefügt und das Sensorelement in eine Öffnung der mittleren Platte eingefügt, wobei das Sensorelement die Leiterbahn der unteren Platte berührt. Auf dem vor dem Einsetzen des Sensorelements freiliegenden Bereich dieser Leiterbahn wird vorzugsweise eine Leiterpaste angeordnet, die später nach dem Einbrennen eine stabile leitende Verbindung zwischen dem Sensorelement und der Leiterbahn herstellt. Die obere Platte wird derart mit der mittleren Platte verbunden, dass das Sensorelement zwischen den Platten eingeschlossen wird, wobei eine auf der Unterseite der oberen Platte angeordnete Leiterbahn die Leiterbahn der mittleren Platte und das Sensorelement berührt.

Vor der Aufbringung der oberen Platte kann auf das Sensorelement und/oder die Leiterbahn der mittleren Platte eine Leiterpaste angeordnet werden, die nach dem Einbrennen eine stabile leitende Verbindung zwischen dem Sensorelement und der Leiterbahn der oberen Platte sowie zwischen den aufeinander liegenden Leiterbahnen der oberen und mittleren Platte herstellt.

Die aufeinander treffenden, innen liegenden Leiterbahnen der aufeinander folgenden Platten können alternativ im folgenden Verfahren fest miteinander verbunden werden. In den zwischen den Platten angeordneten Zwischenraum, der den Bereich der aufeinander liegenden Leiterbahnen umfasst, wird von unten eine Leiterpaste eingeführt. Die Leiterpaste wird vorzugsweise über eine in der untersten Platte ausgebildete Öffnung eingeführt.

Nach der Aufbringung der oberen Platte wird die Plattenanordnung mit dem eingeschlossenen Sensorelement vorzugsweise bis zu einer Temperatur von ca. 800-1100°C erwärmt, wobei die Leiterpaste eingebrannt wird.

Das Bauelement mit dem eingebetteten Sensorelement sowie Verfahrensschritte werden nun anhand von nicht maßstabgetreuen und schematischen Figuren erläutert. Es zeigen:
Figur 1 das Zusammenfügen der unteren und der mittleren Platte;
Figur 2 das Einsetzen des Sensorelements;
Figur 3 das Aufbringen der oberen Platte;
Figur 4 das Einspritzen der Leiterpaste in den Innenraum der Plattenanordnung von unten;
Figur 5 das Aufbringen der oberen Platte auf die mittlere Platte, wobei zwischen den Leiterbahnen eine Leiterpaste vor dem Verbinden der Platten angeordnet wird;
Figur 6 eine fertige Plattenanordnung mit dem integrierten Sensorelement;
Figur 7 die Plattenanordnung im Querschnitt in einem Bereich, der frei von Leiterbahnen ist;
Figur 8 eine Ansicht auf die Plattenanordnung gemäß den Figuren 6, 7 von oben.

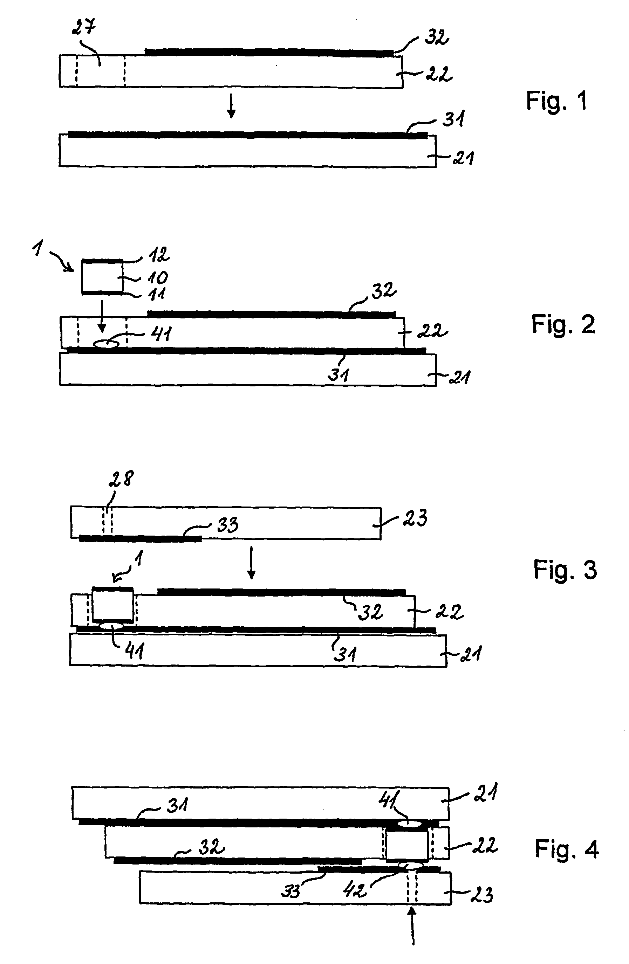

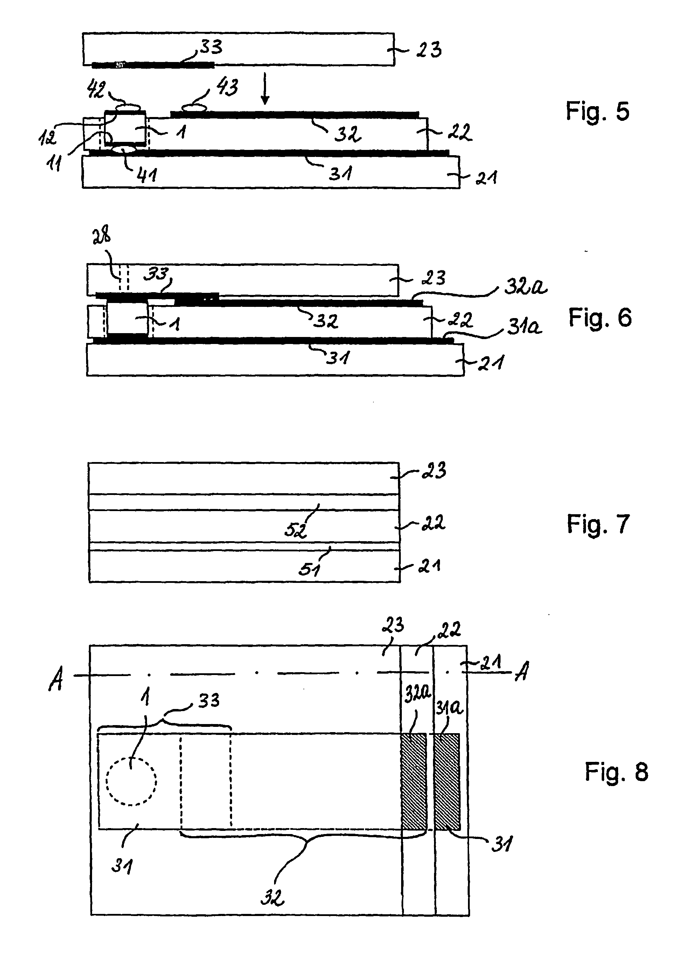

Figur 1 zeigt eine erste endständige Platte 21 und eine mittlere Platte 22, die zusammengefügt werden. Vor dem Zusammenfügen wird auf zumindest eine dieser Platten eine Verbindungsschicht 51 aufgetragen, die in der Figur 7 zu sehen ist.

Auf der Platte 21 ist eine erste Leiterbahn 31 und auf der Platte 22 eine zweite Leiterbahn 32 aufgetragen. Die Länge der Leiterbahnen 31, 32 ist so gewählt, dass sie von den Kanten der jeweiligen Platte beabstandet sind.

Die Platte 22 weist eine durchgehende Öffnung 27 auf. Nach dem Verbinden der Platten 21, 22 (Fig. 2) wird durch die Öffnung 27 der mittleren Platte 22 und die Oberfläche der unteren Platte 21 ein Sackloch gebildet, auf dessen Boden ein Teil der ersten Leiterbahn 31 angeordnet ist. In dieses Sackloch wird eine Leiterpaste 41 und dann ein Sensorelement 1 eingefügt.

Das Sensorelement 1 umfasst einen Körper 10 und zwei Elektroden 11, 12, zwischen denen der Körper 10 angeordnet ist. Die Dicke des Körpers 10 ist vorzugsweise im Wesentlichen gleich der Dicke der mittleren Platte 22.

Die Leiterpaste 41 ist zwischen der unteren Elektrode 11 des Sensorelements 1 und der Leiterbahn 31 angeordnet.

Anschließend wird eine zweite endständige Platte 23 mit der mittleren Platte und dem darin angeordneten Sensorelement verbunden (Fig. 3). Vor dem Zusammenfügen wird auf zumindest eine der Platten 22, 23 eine Verbindungsschicht 52 aufgetragen, die in der Figur 7 zu sehen ist.

Auf der nach innen gewandten Seite der Platte 23 ist eine dritte Leiterbahn 33 angeordnet, die einerseits an die Elektrode 12 des Sensorelements 1 und andererseits an die zweite Leiterbahn 32 angepresst wird.

In der Platte 23 ist vorzugsweise eine durchgehende Öffnung 28 ausgebildet, die in der in Fig. 4 vorgestellten Variante zur Einführung einer Leiterpaste in den zwischen den Platten 22, 23 gebildeten Innenraum vorgesehen ist. Diese Öffnung kann an einer beliebigen Stelle der Leiterbahn 33 einmünden.

In einer in Fig. 4 vorgestellten Verfahrensvariante wird die bisher gebildete Plattenanordnung umgedreht. Über die Öffnung 28 der zweiten endständigen Platte 23 wird von unten eine Leiterpaste 42 eingespritzt. Beim Aufwärmen der Plattenanordnung benetzt die Leiterpaste 42 die ganze Fläche der Leiterbahn 33, wobei insbesondere eine feste und elektrische Verbindung zwischen den Leiterbahnen 33, 32 sowie zwischen der Leiterbahn 33 und der Elektrode 12 des Sensorelements zustande kommt.

In Figur 5 ist eine weitere Variante vorgestellt, wobei die Leiterpaste 42, 43 noch vor der Aufbringung der Platte 23 auf mindestens einer Leitfläche angeordnet wird, die - je nach Ausrichtung der Plattenanordnung - aus den Leiterbahnen 32, 33 und der Elektrode 12 des Sensorelements ausgewählt ist. In diesem Fall kann auf die Öffnung 28 verzichtet werden.

Die fertige Plattenanordnung ist in den Figuren 6, 7 und 8 gezeigt. Dabei ist in Fig. 7 der Querschnitt AA parallel zur Längsrichtung der Plattenanordnung gezeigt. In diesem Bereich weist die Plattenanordnung keine Leiterbahnen auf.

Zwischen den Platten 21, 22 ist eine Verbindungsschicht 51 und zwischen den Platten 22, 23 eine weitere Verbindungsschicht 52 angeordnet. Die Verbindungsschicht 52 kann geringfügig dicker sein als die Schicht 51, da zwischen den Platten 22, 23 zwei Leiterbahnen 32, 33 übereinander angeordnet sind, während zwischen den Platten 21, 22 nur eine Leiterbahn 31 angeordnet ist.

Die Platten 21, 22, 23 sind so dimensioniert und so übereinander gelegt, dass ihre Kanten in einer Lateralebene auf mindestens einer Seite einander gegenüber versetzt sind. Die Bereiche 31a, 32a der ersten und der zweiten Leiterbahn 31, 32 liegen dabei frei. Die freiliegenden Bereiche 31a, 32a bilden Kontaktflächen, die von ein und derselben Seite - in Fig. 6 von oben - kontaktierbar sind.

Das angegebene Bauelement ist auf die Form und Anzahl der in den Figuren gezeigten Elemente und die angegebenen Materialien nicht beschränkt.

### Bezugszeichen

- 1: Sensorelement
- 10: Körper des Sensorelements
- 11, 12: Elektroden des Sensorelements
- 21: untere Platte
- 22: mittlere Platte
- 23: obere Platte
- 27, 28: Öffnung
- 31, 32, 33: Leiterbahn
- 31a: freiliegender Bereich der Leiterbahn 31
- 32a: freiliegender Bereich der Leiterbahn 32
- 41, 42, 43: Leiterpaste
- 51, 52: Verbindungsschicht

## Patentansprüche

1. Elektrisches Bauelement mit einem Sensorelement, bei dem
- mindestens eine untere Platte (21), eine mittlere Platte (22) und eine obere Platte (23) vorhanden sind und die mittlere Platte (22) zwischen der unteren Platte (21) und der oberen Platte (23) angeordnet ist,
- die mittlere Platte (22) eine durchgehende Öffnung (27) oder eine Nische aufweist, wobei die Nische dadurch gebildet ist, dass die mittlere Platte (22) gegenüber der unteren Platte (21) und der oberen Platte (23) abgesetzt ist,
- das Sensorelement (1) zwischen der unteren Platte (21) und der oberen Platte (23) in der Öffnung (27) oder Nische angeordnet ist und
- zwischen der unteren Platte (21) und der mittleren Platte (22) eine erste auf der unteren Platte (21) aufgetragene Leiterbahn (31) angeordnet ist, die mit einer Elektrode (11) des Sensorelementes (1) elektrisch leitend verbunden ist,
- die erste Leiterbahn (31) einen freiliegenden Bereich (31a) aufweist, so dass die Elektrode (11) des Sensorelementes (1) mit dem freiliegenden Bereich (31a) der ersten Leiterbahn (31) elektrisch leitend verbunden ist,
**dadurch gekennzeichnet, dass**
- zwischen der oberen Platte (23) und der mittleren Platte (22) eine zweite auf der mittleren Platte (22) aufgetragene Leiterbahn (32) und eine dritte auf der oberen Platte (23) aufgetragene Leiterbahn (33) angeordnet sind, wobei die dritte Leiterbahn (33) einerseits mit einer weiteren Elektrode (12) des Sensorelementes (1) und andererseits mit der zweiten Leiterbahn (32) elektrisch leitend verbunden ist, und die zweite Leiterbahn (32) einen weiteren freiliegenden Bereich (32a) aufweist, so dass die weitere Elektrode (12) des Sensorelementes (1) mit dem weiteren freiliegenden Bereich (32a) der zweiten Leiterbahn (32) elektrisch leitend verbunden ist.

2. Elektrisches Bauelement nach Anspruch 1, bei dem das Sensorelement (1) ein Temperaturfühler ist und einen Körper (10) umfasst, der NTC-Keramik enthält.

3. Elektrisches Bauelement nach Anspruch 2, bei dem die NTC-Keramik eine Keramikzusammensetzung aufweist, die auf einem phasenhomogenen System
BaIIₓ La^{III}₁₋ₓ Ti^{IV}_{x+y} Co^{II}y Co^{III}_{1-x-2y} O₃
mit Perowskitstruktur basiert.

4. Elektrisches Bauelement nach einem der Ansprüche 1 bis 3, bei dem
die Leiterbahnen (31, 32, 33) aus einer leitfähigen Paste gebildet sind, die Partikel aus AgPt, AgPd und/oder Pt enthält.

5. Elektrisches Bauelement nach einem der Ansprüche 1 bis 4, bei dem
die dritte Leiterbahn (33) komplett in der Plattenanordnung verborgen ist.

6. Elektrisches Bauelement nach einem der Ansprüche 1 bis 5, bei dem
die freiliegenden Bereiche (31a, 32a) der Leiterbahnen (31, 32, 33) von ein und derselben Seite kontaktierbar sind.

7. Elektrisches Bauelement nach einem der Ansprüche 1 bis 6, bei dem
die Platten (21, 22, 23) eine elektrisch isolierende Keramik umfassen.

8. Elektrisches Bauelement nach einem der Ansprüche 1 bis 7, bei dem
die aufeinander folgenden Platten (21, 22, 23) in den von den Leiterbahnen (31, 32, 33) freien Bereichen durch eine Verbindungsschicht (51, 52) miteinander verbunden sind.

9. Verfahren zur Verkapselung eines Sensorelementes, mit den Schritten:
- drei Platten (21, 22, 23) werden mit je einer Leiterbahn (31, 32, 33) versehen,
- die erste und die zweite Platte (21, 22) werden zusammengefügt, so dass die Leiterbahn (31) der ersten Platte (21) zwischen der ersten Platte (21) und der zweiten Platte (22) angeordnet wird und die zweite Leiterbahn (32) der zweiten Platte (22) sich auf der von der ersten Platte (21) abgewandten Seite der zweiten Platte (22) befindet,
- das Sensorelement (1) wird in eine Öffnung (27) der zweiten Platte (22) oder in eine Nische, die dadurch gebildet ist, dass die zweite Platte (22) zu der ersten Platte (21) versetzt angeordnet wird, eingefügt, so dass eine Elektrode (11) des Sensorelementes (1) elektrisch leitend mit der Leiterbahn (31) der ersten Platte (21) verbunden wird, und
- die dritte Platte (23) wird derart mit der zweiten Platte (22) verbunden, dass das Sensorelement (1) zwischen der ersten Platte (21) und der dritten Platte (23) angeordnet wird und die Leiterbahn (33) der dritten Platte (23) elektrisch leitend mit einer weiteren Elektrode (12) des Sensorelementes (1) und mit der Leiterbahn (32) der zweiten Platte (22) verbunden wird,
- wobei die Leiterbahn (31) der ersten Platte (21) und die Leiterbahn (32) der zweiten Platte (22) jeweils einen freiliegenden Bereich (31a, 32a) aufweisen, so dass die Elektroden (11, 12) des Sensorlementes (1) mit jeweils einem der freiliegenden Bereiche (31a, 32a) elektrisch leitend verbunden sind.

10. Verfahren nach Anspruch 9, bei dem
die Leiterbahnen (31, 32, 33) aus einer leitfähigen Paste, die Partikel aus AgPt, AgPd und/oder Pt enthält, gebildet werden.

11. Verfahren nach Anspruch 9 oder 10, bei dem in der dritten Platte (23) eine durchgehende Öffnung (28) ausgebildet wird und
nach dem Verbinden der Platten durch diese Öffnung (28) eine Leiterpaste (42) eingespritzt wird.

12. Verfahren nach Anspruch 9 oder 10, bei dem zwischen der Leiterbahn (31) der ersten Platte (21) und der darauf angeordneten Elektrode (11) des Sensorelementes (1) eine Leiterpaste (41) angeordnet wird und zwischen der Leiterbahn (33) der dritten Platte (23) und der weiteren Elektrode (12) des Sensorelementes (1) sowie der Leiterbahn (32) der zweiten Platte (22) eine Leiterpaste (42) angeordnet wird.

13. Verfahren nach einem der Ansprüche 9 bis 12, bei dem die Platten (21, 22, 23) so dimensioniert und so übereinander gelegt werden, dass ihre Kanten in einer Lateralebene auf mindestens einer Seite zueinander versetzt sind und Bereiche (31a, 32a) der Leiterbahnen (31, 32) der ersten Platte (21) und der zweiten Platte (22) frei liegen, so dass die freiliegenden Bereiche (31a, 32a) Kontaktflächen bilden, die von ein und derselben Seite kontaktierbar sind.

14. Verfahren nach einem der Ansprüche 9 bis 13, bei dem zwischen der ersten Platte (21) und der zweiten Platte (22) eine Verbindungsschicht (51) und zwischen der zweiten Platte (22) und der dritten Platte (23) eine weitere Verbindungsschicht (52) angeordnet wird.

## Claims

1. Electrical component comprising a sensor element, in which
- there is at least one lower plate (21), a middle plate (22) and an upper plate (23) and the middle plate (22) is arranged between the lower plate (21) and the upper plate (23),
- the middle plate (22) has a through-opening (27) or a niche, the niche being formed by the middle plate (22) being offset with respect to the lower plate (21) and the upper plate (23),
- the sensor element (1) is arranged between the lower plate (21) and the upper plate (23), in the opening (27) or niche, and
- arranged between the lower plate (21) and the middle plate (22) is a first conductor track (31), which is applied to the lower plate (21) and is connected in an electrically conducting manner to an electrode (11) of the sensor element (1),
- the first conductor track (31) has an exposed region (31a), so that the electrode (11) of the sensor element (1) is connected in an electrically conducting manner to the exposed region (31a) of the first conductor track (31),
**characterized in that**
- arranged between the upper plate (23) and the middle plate (22) are a second conductor track (32), applied to the middle plate (22), and a third conductor track (33), applied to the upper plate (23), the third conductor track (33) being connected in an electrically conducting manner on the one hand to a further electrode (12) of the sensor element (1) and on the other hand to the second conductor track (32), and the second conductor track (32) having a further exposed region (32a), so that the further electrode (12) of the sensor element (1) is connected in an electrically conducting manner to the further exposed region (32a) of the second conductor track (32).

2. Electrical component according to Claim 1, in which the sensor element (1) is a temperature sensor and comprises a body (10) that contains NTC ceramic.

3. Electrical component according to Claim 2, in which the NTC ceramic has a ceramic composition that is based on a phase-homogeneous system
Ba^{II}ₓ La^{III}₁₋ₓ Ti^{IV}_{x+y} Co^{II}_{y} CO^{III}_{1-x-2y} O₃
with a perovskite structure.

4. Electrical component according to one of Claims 1 to 3, in which
the conductor tracks (31, 32, 33) are formed from a conductive paste that contains particles of AgPt, AgPd and/or Pt.

5. Electrical component according to one of Claims 1 to 4, in which
the third conductor track (33) is completely concealed within the plate arrangement.

6. Electrical component according to one of Claims 1 to 5, in which
the exposed regions (31a, 32a) of the conductor tracks (31, 32, 33) can be contacted from one and the same side.

7. Electrical component according to one of Claims 1 to 6, in which
the plates (21, 22, 23) comprise an electrically insulating ceramic.

8. Electrical component according to one of Claims 1 to 7, in which
the successive plates (21, 22, 23) are connected to one another in the regions free from the conductor tracks (31, 32, 33) by a connecting layer (51, 52).

9. Method for encapsulating a sensor element, comprising the steps that:
- three plates (21, 22, 23) are each provided with a conductor track (31, 32, 33),
- the first and the second plate (21, 22) are joined together, so that the conductor track (31) of the first plate (21) is arranged between the first plate (21) and the second plate (22) and the second conductor track (32) of the second plate (22) is located on the side of the second plate (22) that is facing away from the first plate (21),
- the sensor element (1) is inserted into an opening (27) in the second plate (22) or into a niche that is formed by the second plate (22) being arranged offset in relation to the first plate (21), so that an electrode (11) of the sensor element (1) is connected in an electrically conducting manner to the conductor track (31) of the first plate (21), and
- the third plate (23) is connected to the second plate (22) in such a way that the sensor element (1) is arranged between the first plate (21) and the third plate (23) and the conductor track (33) of the third plate (23) is connected in an electrically conducting manner to a further electrode (12) of the sensor element (1) and to the conductor track (32) of the second plate (22),
- the conductor track (31) of the first plate (21) and the conductor track (32) of the second plate (22) respectively having an exposed region (31a, 32a), so that the electrodes (11, 12) of the sensor element (1) are respectively connected in an electrically conducting manner to one of the exposed regions (31a, 32a).

10. Method according to Claim 9, in which the conductor tracks (31, 32, 33) are formed from a conductive paste that contains particles of AgPt, AgPd and/or Pt.

11. Method according to Claim 9 or 10, in which a through-opening (28) is formed in the third plate (23) and
after the plates have been connected, a conductor paste (42) is injected through this opening (28).

12. Method according to Claim 9 or 10, in which a conductor paste (41) is arranged between the conductor track (31) of the first plate (21) and the electrode (11) of the sensor element (1) that is arranged thereupon and a conductor paste (42) is arranged between the conductor track (33) of the third plate (23) and the further electrode (12) of the sensor element (1) and the conductor track (32) of the second plate (22).

13. Method according to one of Claims 9 to 12, in which the plates (21, 22, 23) are dimensioned and placed one on top of the other in such a way that their edges are offset in relation to one another in a lateral plane on at least one side and regions (31a, 32a) of the conductor tracks (31, 32) of the first plate (21) and of the second plate (22) are exposed, so that the exposed regions (31a, 32a) form contact areas that can be contacted from one and the same side.

14. Method according to one of Claims 9 to 13, in which a connecting layer (51) is arranged between the first plate (21) and the second plate (22) and a further connecting layer (52) is arranged between the second plate (22) and the third plate (23).

## Revendications

1. Composant électrique doté d'un élément de capteur, dans lequel
au moins une plaque inférieure (21), une plaque centrale (22) et une plaque supérieure (23) sont prévues, la plaque centrale (22) étant disposée entre la plaque inférieure (21) et la plaque supérieure (23),
la plaque centrale (22) est traversée par une ouverture (27) ou présente une niche, la niche étant formée par un décalage de la plaque centrale (22) à la plaque inférieure (21) et la plaque supérieure (23),
l'élément de capteur (1) est disposé dans l'ouverture (27) ou la niche entre la plaque inférieure (21) et la plaque supérieure (23),
une première piste conductrice (31) appliquée sur la plaque inférieure (21) et raccordée de manière électriquement conductrice à une électrode (11) de l'élément de capteur (1) est disposée entre la plaque inférieure (21) et la plaque centrale (22),
la première piste conductrice (31) présente une partie libre (31a) de telle sorte que l'électrode (11) de l'élément de capteur (1) soit reliée de manière électriquement conductrice à la partie libre (31a) de la première piste conductrice (31),
**caractérisé en ce que**
une deuxième piste conductrice (32) appliquée sur la plaque centrale (22) et une troisième piste conductrice (33) appliquée sur la plaque supérieure (23) sont disposées entre la plaque supérieure (23) et la plaque centrale (22),
**en ce que** la troisième piste conductrice (33) est raccordée de manière électriquement conductrice d'une part à une autre électrode (12) de l'élément de capteur (1) et d'autre part à la deuxième piste conductrice (32),
**en ce que** la deuxième piste conductrice (32) présente une autre partie libre (32a), de telle sorte que l'autre électrode (12) de l'élément de capteur (1) est raccordée de manière électriquement conductrice à l'autre partie libre (32a) de la deuxième piste conductrice (32).

2. Composant électrique selon la revendication 1, dans lequel l'élément de capteur (1) est une sonde de température et comporte un corps (10) en céramique NTC.

3. Composant électrique selon la revendication 2, dans lequel la céramique NTC présente une composition de céramique à base d'un système en phase homogène de Ba^{II}ₓLa^{III}₁₋ₓTi^{IV}_{x+y}Co^{II}_{y}Co^{III}_{1-x-2y}O₃ à structure de perovskite.

4. Composant électrique selon l'une des revendications 1 à 3, dans lequel les pistes conductrices (31, 32, 33) sont formées d'une pâte conductrice qui contient des particules d'AgPt, d'AgPd et/ou de Pt.

5. Composant électrique selon l'une des revendications 1 à 4, dans lequel la troisième piste conductrice (33) est complètement cachée dans l'ensemble de plaque.

6. Composant électrique selon l'une des revendications 1 à 5, dans lequel les parties libres (31a, 32a) des pistes conductrices (31, 32, 33) peuvent être mises en contact d'un seul et même côté.

7. Composant électrique selon l'une des revendications 1 à 6, dans lequel les plaques (21, 22, 23) comprennent une céramique électriquement isolante.

8. Composant électrique selon l'une des revendications 1 à 7, dans lequel les plaques successives (21, 22, 23) sont raccordées les unes aux autres par une couche de liaison (51, 52) dans les parties libres des pistes conductrices (31, 32, 33).

9. Procédé d'encapsulation d'un élément de capteur, le procédé comportant les étapes qui consistent à :
doter trois plaques (21, 22, 23) de chacune une piste conductrice (31, 32, 33),
assembler la première et la deuxième plaque (21, 22) de telle sorte que la piste conductrice (31) de la première plaque (21) soit disposée entre la première plaque (21) et la deuxième plaque (22) et que la deuxième piste conductrice (32) de la deuxième plaque (22) soit située sur le côté de la deuxième plaque (22) non tourné vers la première plaque (21),
insérer l'élément de capteur (1) dans une ouverture (27) de la deuxième plaque (22) ou dans une niche formée par le fait que la deuxième plaque (22) est décalée par rapport à la première plaque (21), de telle sorte qu'une électrode (11) de l'élément de capteur (1) soit raccordée de manière électriquement conductrice à la piste conductrice (31) de la première plaque (21),
relier la troisième plaque (23) à la deuxième plaque (22) de telle sorte que l'élément de capteur (1) soit disposé entre la première plaque (21) et la troisième plaque (23) et que la piste conductrice (33) de la troisième plaque (23) soit raccordée de manière électriquement conductrice à une autre électrode (12) de l'élément de capteur (1) et à la piste conductrice (32) de la deuxième plaque (22),
la piste conductrice (31) de la première plaque (21) et la piste conductrice (32) de la deuxième plaque (22) présentant chacune une partie libre (31a, 32a) de telle sorte que les électrodes (11, 12) de l'élément de capteur (1) soient reliées de manière électriquement conductrice chacune à l'une des parties libres (31a, 32a).

10. Procédé selon la revendication 9, dans lequel les pistes conductrices (31, 32, 33) sont formées d'une pâte conductrice qui contient des particules d'AgPt, AgPd et/ou Pt.

11. Procédé selon les revendications 9 ou 10, dans lequel une ouverture (28) est ménagée à travers la troisième plaque (23), une pâte conductrice (42) étant injectée par cette ouverture (28) après que les plaques ont été reliées.

12. Procédé selon les revendications 9 ou 10, dans lequel une pâte conductrice (41) est disposée entre la piste conductrice (31) de la première plaque (21) et l'électrode (11) de l'élément de capteur (1) qui y est disposée et une pâte conductrice (42) est disposée entre la piste conductrice (33) de la troisième plaque (23) et l'autre électrode (12) de l'élément de capteur (1) ainsi que la piste conductrice (32) de la deuxième plaque (22).

13. Procédé selon l'une des revendications 9 à 12, dans lequel les plaques (21, 22, 23) sont dimensionnées et superposées de telle sorte que leurs bords soient décalés mutuellement sur au moins un côté dans un plan latéral et que des parties (31a, 32a) des pistes conductrices (31, 32) de la première plaque (21) et de la deuxième plaque (22) soient libérées de telle sorte que les parties libres (31a, 32a) forment des surfaces de contact qui peuvent être mises en contact par un seul et même côté.

14. Procédé selon l'une des revendications 9 à 13, dans lequel une couche de liaison (51) est disposée entre la première plaque (21) et la deuxième plaque (22) et une autre couche de liaison (52) est disposée entre la deuxième plaque (22) et la troisième plaque (23).
